# EUROPEAN PATENT SPECIFICATION

(11) **EP 2 202 064 B1**
(45) Date of publication and mention of the grant of the patent: **21.09.2016**
(21) Application number: 08836426.0
(22) Date of filing: 30.09.2008
(51) Int. Cl.: B32B 27/18, B32B 9/00

(54) **LIGHT-RESISTANT FILM**
LICHTBESTÄNDIGER FILM
FILM RÉSISTANT À LA LUMIÈRE

(30) Priority: 01.10.2007 JP 2007257777
(43) Date of publication of application: 30.06.2010
(73) Proprietor: Teijin Dupont Films Japan Limited, Chiyoda-ku Tokyo 100-0013 (JP)
(72) Inventor: NISHIO, Rei, Anpachi-gun Gifu 503-0123 (JP); KUBO, Koji, Anpachi-gun Gifu 503-0123 (JP)
(74) Representative: Cockerton, Bruce Roger
(86) International application number: PCT/JP2008/068127
(87) International publication number: WO 2009/044905

(56) References cited:
- JP-A- 6 114 992
- JP-A- 11 040 833
- JP-A- 2003 092 421
- JP-A- 2006 253 565
- JP-A- 2006 326 971

## Description

### TECHNICAL FIELD

The present invention relates to a light stabilized film that blocks an ultraviolet ray through absorption of an ultraviolet ray, and has light stability to an ultraviolet ray stably for a prolonged period of time.

### BACKGROUND ART

A thermoplastic resin film has high versatility and is used in a wide range of fields. A thermoplastic resin, such as polyester, polyamide, polyolefin, polyether and polystyrene, suffers deterioration or decomposition due to action of an ultraviolet ray, which brings about discoloration or decrease of mechanical strength, thereby suffering difficulty in use for a prolonged period of time. Various kinds of ultraviolet ray absorbents have been used for preventing deterioration, and a thermoplastic resin film containing an ultraviolet ray absorbent is being widely used for such purposes as adhesion to windows, a plastic greenhouse, insect proofing and the like.

An inorganic ultraviolet ray absorbent and an organic ultraviolet ray absorbent have ordinarily been known as the ultraviolet ray absorbent, and an inorganic ultraviolet ray absorbent absorbs light within a relatively wide wavelength range, and thus absorbs visible light when an ultraviolet ray is to be absorbed completely, thereby providing low transmittance in the visible light region. An organic ultraviolet ray absorbent, on the other hand, absorbs light within a relatively narrow wavelength range, and thus can absorb an ultraviolet ray while maintaining the transmittance in the visible light range. However, the organic ultraviolet ray absorbent is insufficient in light stability by itself and is particularly difficult to maintain stable light stability under strong direct sunlight for a prolonged period of time (see JP-A-7-11231, JP-A-7-11232, JP-A-2000-254518, JP-A-2000-106993 and JP-A-2006-326971).

### DISCLOSURE OF THE INVENTION

### Problems to be solved by the Invention

An object of the invention is to provide a light stabilized film that maintains good light stability under light irradiation for a prolonged period of time while containing an organic ultraviolet ray absorbent.

### Means for solving the Problems

Accordingly, the invention relates to a light stabilized film containing a resin film wherein the resin is polyethylene naphthalene carboxylate, a first light stabilized layer being formed on the resin film and containing an organic ultraviolet ray absorbent of a benzophenone series, and a second light stabilized layer being formed on the first light stabilized layer and containing a metallic oxide having ultraviolet ray absorbability, wherein the metallic oxide is zinc oxide.

### BEST MODE FOR CARRYING OUT THE INVENTION

The invention will be described in detail below.

### Resin Film

The resin film is constituted by a thermoplastic resin. The thermoplastic resin used is polyethylene naphthalene carboxylate.

The resin film in the invention may be a single layer film or a laminated film containing plural layers.

### First Light stabilized Layer

The first light stabilized layer is provided on the resin film, and contains an organic ultraviolet ray absorbent. The first light stabilized layer may contain, in addition to the organic ultraviolet ray absorbent, for example, a resin binder and a light stabilizer.

### Organic Ultraviolet Ray Absorbent

The organic ultraviolet ray absorbent contained in the first light stabilized layer is an organic ultraviolet ray absorbent of a benzophenone series. Organic ultraviolet ray absorbents of a benzophenone series are used owing to the high absorbance of an ultraviolet ray.

Examples of the benzophenone organic ultraviolet ray absorbent include 2,2-dihydroxy-4-methoxybenzophenone, 2-hydroxy-4-octoxybenzophenone and 2-hydroxy-4-methoxybenzophenone.

The organic ultraviolet ray absorbent may be used solely or in combination of plural kinds thereof. Both a low molecular weight compound or a high molecular weight compound thereof may be used.

### Resin Binder

The first light stabilized layer may contain a resin binder. The resin binder may be in a mixed state or in a chemically bonded state.

In the case where the first light stabilized layer contains a resin binder, a transparent resin is preferably used as the resin binder, examples of which include a polyester resin, an acrylic resin, a fluorine resin, a silicone resin, a melamine resin, a vinyl chloride resin, a vinyl butyral resin, a cellulose resin and a polyamide resin, and among these, an acrylic resin and a silicone resin that are excellent in light stability are preferred.

The ratio of the organic ultraviolet ray absorbent contained in the first light stabilized layer is preferably 5 to 100% by weight, and more preferably 10 to 100% by weight, per 100% by weight of the total components constituting the first light stabilized layer. A ratio of less than 5% by weight is not preferred since the absorption efficiency of an ultraviolet ray is decreased, and thus the layer is necessarily coated thickly for imparting sufficient ultraviolet ray absorbability.

### Light Stabilizer

The first light stabilized layer may further contain a light stabilizer.

The light stabilizer includes two kinds, i.e., a quencher and HALS. The quencher generally has a function of de-exciting an active molecule in an excited state (for example, singlet oxygen ¹O₂). The HALS is considered as functioning as a scavenger that scavenges radicals generated by an ultraviolet ray. Both the quencher and the HALS may be used as the light stabilizer. As the HALS as the light stabilizer, for example, a hindered amine compound may be used.

The light stabilizer is generally contained in a dispersed state in the first light stabilized layer. The stabilizer contained in the first light stabilized layer enhances the light stability of the organic ultraviolet ray absorbent and the resin binder for a prolonged period of time.

In the case where the light stabilizer is contained in the first light stabilized layer, the content thereof is, for example, 0.01 to 30% by weight, and preferably 0.1 to 20% by weight, per 100% by weight of the organic ultraviolet ray absorbent.

### Thickness of First Light stabilized Layer

The thickness of the first light stabilized layer is preferably 0.03 to 35 µm, and more preferably 0.05 to 20 µm. A thickness within the range can provide sufficient light stability and transparency and good handleability of the film.

### Method for forming First Light stabilized Layer

The first light stabilized layer can be provided on the resin film, for example, by coating or vapor deposition. In the case of coating, for example, a wet coating method may be employed, in which a coating composition containing a composition for the coated layer dissolved or dispersed in a solvent is coated on the resin film.

The wet coating may be performed by a roll method, a dipping method, an air knife method, a blade method, a wire bar method, a slide hopper method, an extrusion method, a curtain method or the like. A spinning method and a spraying method with a versatile machine may also be employed. A wet printing method may also be employed for coating, such as the three major printing methods, i.e., anastatic printing, offset printing and gravure printing, and copperplate printing, rubber plate printing and screen printing. A preferred coating method may be selected from these methods corresponding to the viscosity of the composition and the wet thickness.

### Second Light stabilized Layer

The second light stabilized layer is provided on the first light stabilized layer, and contains a metallic oxide having ultraviolet ray absorbability. In the invention, the resin film, the first light stabilized layer and the second light stabilized layer are provided in this order, and used in such a manner that the side of the second light stabilized layer is directed to the incident surface of light for providing light stability for a prolonged period of time.

In the invention, the second light stabilized layer containing a metallic oxide having ultraviolet ray absorbability is disposed above the first light stabilized layer, i.e., on the incident side of light. According to the structure, the organic ultraviolet ray absorbent in the first light stabilized layer can be maintained in a stable state for a prolonged period of time.

### Metallic Oxide

The metallic oxide having ultraviolet ray absorbability used in the second light stabilized layer is used for the purpose of absorbing such light of a wavelength that deteriorates the organic ultraviolet ray absorbent used in the first light stabilized layer. The metallic oxide used is zinc oxide. The metallic oxide may be mixed in the form of particles into the second light stabilized layer or may be formed into a thin film.

In the case where the metallic oxide is used as particles, a part of the surface of the metallic oxide may be covered with aluminum oxide or silicon oxide, thereby preventing deterioration of the surrounding organic materials due to photocatalytic reaction.

In the case where the metallic oxide is coated as particles, the average particle diameter of the particles is preferably 0.1µm or less, and more preferably 0.05 µm or less, for maintaining the light transmittance. The use of a particle diameter within the range maintains the light transmittance, and the metallic oxide can be coated densely, thereby enhancing the shielding capability to an ultraviolet ray.

### Resin Binder

The second light stabilized layer may contain a resin binder. The resin binder may be in a mixed state or in a chemically bonded state.

In the case where the second light stabilized layer contains a resin binder, a transparent resin is preferably used as the resin binder, examples of which include a polyester resin, an acrylic resin, a fluorine resin, a silicone resin, a melamine resin, a vinyl chloride resin, a vinyl butyral resin, a cellulose resin and a polyamide resin, and among these, an acrylic resin and a silicone resin that are excellent in light stability are preferred.

The ratio of the metallic oxide contained in the second light stabilized layer is preferably 5 to 100% by weight, and more preferably 10 to 100% by weight, per 100% by weight of the total components constituting the second light stabilized layer. A ratio of less than 5% by weight is not preferred since the absorption efficiency of an ultraviolet ray is decreased, and thus the layer is necessarily coated thickly for imparting sufficient ultraviolet ray absorbability.

### Light Stabilizer

The second light stabilized layer may further contain a light stabilizer.

The light stabilizer includes two kinds, i. e. , a quencher and HALS, and the quencher generally has a function of de-exciting an active molecule in an excited state (for example, singlet oxygen ¹O₂). The HALS is considered as functioning as a scavenger that scavenges radicals generated by an ultraviolet ray. Both the quencher and the HALS may be used as the light stabilizer. As the HALS as the light stabilizer, for example, a hindered amine compound may be used.

In the case where the light stabilizer is contained, it is generally contained in a dispersed state in the second light stabilized layer. The light stabilizer contained in the second light stabilized layer enhances the light stability of the resin binder for a prolonged period of time.

In the case where the light stabilizer is contained in the second light stabilized layer, the content thereof is, for example, 0.01 to 30% by weight, and preferably 0.1 to 20% by weight, per 100% by weight of the metallic oxide.

### Thickness of Second Light stabilized Layer

The thickness of the second light stabilized layer is preferably 0.01 to 10 µm, and more preferably 0.05 to 10 µm. A thickness within the range can provide sufficient light stability and transparency and good handleability of the film.

### Method for forming Second Light stabilized Layer

The second light stabilized layer can be provided on the first light stabilized layer, for example, by coating or dry coating.

In the case of coating, for example, a wet coating method may be employed, in which a coating composition containing a composition for the coated layer dissolved or dispersed in a solvent is coated on the first light stabilized layer. The wet coating may be performed, for example, by a roll method, a dipping method, an air knife method, a blade method, a wire bar method, a slide hopper method, an extrusion method or a curtain method. A spinning method and a spraying method with a versatile machine may also be employed. A wet printing method may also be employed for coating, such as the three major printing methods, i.e., anastatic printing, offset printing and gravure printing, and copperplate printing, rubber plate printing and screen printing. A preferred coating method may be selected from these methods corresponding to the viscosity of the composition and the wet thickness.

The dry coating may be performed, for example, by a vapor deposition method, a sputtering method, a CVD method or an ion-plating method.

### Other Layers

### Hardcoat Layer

A hardcoat layer may be provided at one or more of the positions between the resin film and the first light stabilized layer, between the first light stabilized layer and the second light stabilized layer, and on the second light stabilized layer, for enhancing the adhesiveness among the layers and the durability upon using out of doors for a prolonged period of time. The thickness of the hardcoat layer is, for example, 0.01 to 20 µm, and more preferably 0.05 to 10 µm.

The hardcoat layer is preferably formed of a material that has good adhesiveness to the layer in contact thereto, and a thermosetting resin and an energy ray-curable resin are preferred therefor from the standpoint of industrial productivity. Examples of the thermosetting resin and the energy ray-curable resin include an acrylic resin, a urethane resin, a silicone resin and an epoxy resin, and a mixture containing the resin component and inorganic particles, such as alumina, silica and mica, mixed therewith is preferably used.

### Buffer Layer

A buffer layer formed of an inorganic substance having a thickness of 0.01 to 20 µm, and preferably 1 to 10 µm, may be provided adjacent to the second light stabilized layer containing the metallic oxide. The buffer layer provided can prevent light deterioration of the adjacent layers due to photocatalytic reaction by the metallic oxide. For example, the buffer layer may be provided between the first light stabilized layer and the second light stabilized layer, thereby preventing deterioration of the first light stabilized layer due to photocatalytic reaction by the metallic oxide. Examples of the inorganic substance constituting the buffer layer include aluminum oxide and silicon oxide. The buffer layer may also function as the hardcoat layer.

### Antireflection Layer

An antireflection layer may be provided between the layers constituting the light stabilized film of the invention or on the outermost layer thereof. The antireflection layer provided favorably enhances the light transmittance, thereby enabling applications to the fields where the light amount is important, such as a solar cell.

In the case where the antireflection layer is provided on the outermost layer, 1 to 30 layers each having a refractive index of 1.30 to 2.0 and a thickness of 0.01 to 0.2 µm may be laminated to form the antireflection layer. The antireflection layer may be laminated with the hardcoat layer and the buffer layer.

### Adhesive Layer

In the invention, an adhesive layer may be provided on the resin film. In this case, the adhesive layer may be provided between the resin film and the first light stabilized layer or may be provided on the side where the first light stabilized layer is not provided. When the adhesive layer is provided between the resin film and the first light stabilized layer, the adhesiveness between them can be enhanced. When the adhesive layer is provided on the side of the resin film where the first light stabilized layer is not provided, good adhesiveness can be obtained to an object in the case where the light stabilized film of the invention is used, for example, as a cover sheet.

A material that exhibits excellent adhesiveness to both the polyester film and the first light stabilized layer is preferably used as the adhesive layer, and examples of the material used include a polyester resin, an acrylic resin, a urethane-acrylic resin, a silicon-acrylic resin, a melamine resin and a silicone resin. The resins may be used solely or as a mixture of plural kinds thereof.

The thickness of the adhesive layer is preferably 10 to 200 nm, and more preferably 20 to 150 nm. A thickness of the adhesive layer of less than 10 nm is not preferred since only poor effect of enhancing the adhesiveness is obtained, and a thickness exceeding 200 nm is not preferred since the adhesive layer is liable to suffer cohesion failure, which results in decrease of the adhesiveness.

As the method for providing the adhesive layer, a method of providing by coating in the production process of the resin film is preferred. The coating operation is preferably performed by coating a coating composition before completing the orientation and crystallization of the resin film. The film before completing the orientation and crystallization referred herein includes an unstretched film, a uniaxially oriented film obtained by orienting an unstretched film in one of the machine direction or the transversal direction, a film having been stretched and oriented in low ratios in two directions, i.e., the machine direction and the transversal direction (a biaxially stretched film before finally completing the orientation and crystallization by stretching again in the machine direction or the transversal direction), and the like. Among these, the adhesive layer is preferably provided in such a manner that the coating composition is coated on an unstretched film or a uniaxially stretched film, which is then directly subjected to stretching in the machine direction and/or the transversal direction, followed by subjecting to thermal fixing.

### EXAMPLE

The invention will be described in more detail with reference to examples below.

The properties were evaluated in the following manners.

### (1) Light Transmittance

The light transmittance at a wavelength of 390 nm was measured with a spectrophotometer (MPC3100, produced by Shimadzu Corporation).

### (2) Light Stability

An outdoor exposure acceleration test was performed by irradiating a sample film with an UV radiation tester (SUNSTEST CPS+, produced by Atlas Material Testing Technology GmbH) at a temperature of 55°C and an output power of 765 W/m² for 240 hours. After performing the outdoor exposure acceleration test, the coloration of the film was measured in terms of b* value by transmission measurement with SZS-∑90, produced by Nippon Denshoku Industries Co., Ltd., and the difference between the b* value after the test and the b* value before the test was calculated and evaluated according to the following standard. The outdoor exposure acceleration test is abbreviated as test.
A: (b* after test) - (b* before test) ≤ 4 significantly good light stability
B: 4 < (b* after test) - (b* before test) ≤ 8 improved light stability
C: 8 < (b* after test) - (b* before test) poor light stability

### Example 1

### Production of Resin Film

Pellets of polyethylene-2,6-naphthalene dicarboxylate having an intrinsic viscosity of 0.63 and containing substantially no particle were dried at 170°C for 6 hours and then fed to a hopper of an extruder. The pellets were melt-kneaded at a melt temperature of 305°C, filtered with a stainless steel thin wire filter having an average aperture of 17 µm, and extruded through a slit die of 3 mm onto a rotating cooling drum having a surface temperature of 60°C, thereby quenching to provide an unstretched film. The unstretched film was preheated to 120°C and then stretched in the machine direction by 1.1 times between low speed and high speed rollers while heating from the above with an IR heater at 850°C with a distance of 15 mm. A coating composition A described later was coated on one surface of the film having been stretched in the machine direction to make a coated thickness after drying of 0.25 µm with a roll coater to form an adhesive layer.

The film was then fed to a tenter and stretched in the transversal direction by 3.3 times at 140°C. The resulting biaxially oriented film was thermally fixed at a temperature of 245°C for 5 seconds to provide a film having an intrinsic viscosity of 0.58 dL/g and a thickness of 125 µm, and thereafter, the film was subjected to thermal relaxation at a relaxation ratio of 0.7% at a temperature of 205°C in a suspended state to provide a resin film.

### Formation of First Light stabilized Layer

A composition for forming the first light stabilized layer was prepared from 40 parts by weight of Cyasorb UV24 (produced by Nihon Cytech Industries, Inc., 2,2-dihydroxy-4-methoxybenzophenone) as the organic ultraviolet ray absorbent, 54 parts by weight of an acrylic resin, HALS Hybrid UV-G301 (produced by Nippon Shokubai Co,. Ltd.), as the binder, and 6 parts by weight of Desmodur N3200 (produced by Sumitomo Bayer Urethane Co., Ltd.) as an isocyanate curing agent. The composition was dissolved in ethyl acetate to prepare a coating composition as a solution having a solid concentration of 11% by weight. The coating composition was coated on the resin film by using a bar coater, and dried to form the first light stabilized layer having a thickness of 2 µm.

### Formation of Second Light stabilized Layer

A 15% by weight dispersion liquid of zinc oxide fine particles, NanoTek (produced by C.I. Kasei Co. , Ltd., average particle diameter 34 nm) was coated on the first light stabilized layer by using a bar coater, and dried to form the second light stabilized layer having a thickness of 0.1 µm.

The resulting light stabilized film was evaluated for properties. The results are shown in Table 1.

### Example 2

### Production of Resin Film

A resin film was produced in the same manner as in Example 1.

### Formation of First Light stabilized Layer

A coating composition was prepared as a solution having a solid concentration of 24% by weight containing 50 parts by weight of Cyasorb UV24 (produced by Nihon Cytech Industries, Inc., 2,2-dihydroxy-4-methoxybenzophenone) as the organic ultraviolet ray absorbent, 49.8 parts by weight of a silicone binder, TSR145 (produced by Momentive Performance Materials Inc.) as the binder, 0.2 part by weight of a catalyst (CR13 (produced by Momentive Performance Materials Inc.)), dissolved in toluene as a solvent. The coating composition was coated on the resin film by using a bar coater, and dried under heating to form the first light stabilized layer having a thickness of 1.5 µm.

### Formation of Second Light stabilized Layer

The second light stabilized layer was formed in the same manner as in Example 1 to provide a light stabilized film.

The resulting light stabilized film was evaluated for properties. The results are shown in Table 1.

### Example 3

### Production of Resin Film

A resin film was produced in the same manner as in Example 1.

### Formation of First Light stabilized Layer

The first light stabilized layer was produced in the same manner as in Example 2.

### Formation of Second Light stabilized Layer

The second light stabilized layer was formed by accumulating zinc oxide on the first light stabilized layer to a thickness of 100 nm by a sputtering method to provide a light stabilized film.

The resulting light stabilized film was evaluated for properties. The results are shown in Table 1.

### Example 4

### Production of Resin Film

A resin film was produced in the same manner as in Example 1.

### Formation of First Light stabilized Layer

A coating composition was prepared as a solution having a solid concentration of 12% by weight containing 100 parts by weight of Cyasorb UV24 (produced by Nihon Cytech Industries, Inc., 2,2-dihydroxy-4-methoxybenzophenone) as the organic ultraviolet ray absorbent dissolved in toluene as a solvent. The coating composition was coated on the resin film by using a bar coater, and dried to form the first light stabilized layer having a thickness of 0.7 µm.

### Formation of Second Light stabilized Layer

The second light stabilized layer was formed on the first light stabilized layer in the same manner as in Example 3 to provide a light stabilized film.

The resulting light stabilized film was evaluated for properties. The results are shown in Table 1.

### Example 5

The first light stabilized layer was formed on the resin film, and the second light stabilized layer was formed thereon, in the same manner as in Example 3. Furthermore, an antireflection layer was formed by accumulating a layer of silicon oxide having a thickness of 100 nm by a sputtering method as the outermost layer on the second light stabilized layer to provide a light stabilized film having an antireflection layer.

The resulting light stabilized film was evaluated for properties. The results are shown in Table 1.

### Example 6

The first light stabilized layer was formed on the resin film in the same manner as in Example 3. A buffer layer was then formed by accumulating a layer of silicon oxide having a thickness of 50 nm by a sputtering method on the first light stabilized layer. The second light stabilized layer was formed thereon in the same manner as in Example 3 to provide a light stabilized film.

The resulting light stabilized film was evaluated for properties. The results are shown in Table 1.

### Comparative Example 1

A resin film was produced in the same manner as in Example 1. The first light stabilized layer and the second light stabilized layer were not formed on the film.

The film was evaluated for properties. The results are shown in Table 1.

### Comparative Example 2

A resin film was produced in the same manner as in Example 1, and a film having the first light stabilized layer formed thereon was produced in the same manner as in Example 2. The second light stabilized layer was not formed on the film.

The resulting film was evaluated for properties. The results are shown in Table 1.

### Comparative Example 3

A resin film was produced in the same manner as in Example 1, and the second light stabilized film was formed directly on the resin film. The formation method thereof was the same as in Example 3. The first light stabilized layer was not formed on the film.

The resulting film was evaluated for properties. The results are shown in Table 1.

**Table 1**

| | First light stabilized layer | Second light stabilized layer | Light transmittance at 390 nm (%) | Light stability |
|---|---|---|---|---|
| Example 1 | organic ultraviolet ray absorbent Cyasorb UV24 | zinc oxide fine particles | 39.5 | A |
| Example 2 | organic ultraviolet ray absorbent Cyasorb UV24 | zinc oxide fine particles | 40.0 | A |
| Example 3 | organic ultraviolet ray absorbent Cyasorb UV24 | zinc oxide film (sputtering) | 38.7 | A |
| Example 4 | organic ultraviolet ray absorbent Cyasorb UV24 | zinc oxide film (sputtering) | 40.0 | A |
| Example 5 | organic ultraviolet ray absorbent Cyasorb UV24 | zinc oxide film (sputtering) | 43.2 | A |
| Example 6 | organic ultraviolet ray absorbent Cyasorb UV24 | zinc oxide film (sputtering) | 38.0 | A |
| Comparative Example 1 | - | - | 59.5 | C |
| Comparative Example 2 | organic ultraviolet ray absorbent Cyasorb UV24 | - | 45.8 | B |
| Comparative Example 3 | - | zinc oxide film (sputtering) | 51.7 | B |

### Effect of the Invention

According to the invention, such a light stabilized film can be provided that maintains good light stability under light irradiation for a prolonged period of time while containing an organic ultraviolet ray absorbent.

### Industrial Applicability

The light stabilized film of the invention can be favorably used in a purpose where the film is exposed to an ultraviolet ray for a prolonged period of time, such as a member of a solar cell, and a purpose of packaging an article that is necessarily prevented from suffering deterioration due to an ultraviolet ray, such as a pharmaceutical product.

## Claims

1. A light stabilized film comprising
a resin film wherein the resin is polyethylene naphthalene carboxylate,
a first light stabilized layer being formed on the resin film and containing an organic ultraviolet ray absorbent of a benzophenone series, and
a second light stabilized layer being formed on the first light stabilized layer and containing a metallic oxide having ultraviolet ray absorbability, wherein the metallic oxide is zinc oxide.

2. The light stabilized film according to claim 1, which is used as a member of a solar cell.

## Patentansprüche

1. Lichtstabilisierter Film, umfassend
einen Harzfilm, wobei das Harz Polyethylennaphthalincarboxylat ist,
eine erste lichtstabilisierte Schicht, die auf dem Harzfilm gebildet ist und ein organisches Ultraviolettstrahlen-Absorptionsmittel aus einer Benzophenonreihe enthält, und
eine zweite lichtstabilisierte Schicht, die auf der ersten lichtstabilisierten Schicht gebildet ist und ein Metalloxid enthält, das Ultraviolettstrahlen-Absorptionsfähigkeit aufweist, wobei das Metalloxid Zinkoxid ist.

2. Lichtstabiliserter Film gemäß Anspruch 1, das als Element einer Solarzelle verwendet wird.

## Revendications

1. Film photostabilisé comprenant
une pellicule de résine, la résine étant du polyéthylène naphtalène carboxylate,
une première couche photostabilisée étant formée sur la pellicule de résine et contenant un agent absorbant les rayons ultraviolets organique d'une série benzophénone, et
une seconde couche photostabilisée étant formée sur la première couche photostabilisée et contenant un oxyde métallique présentant une capacité d'absorption des rayons ultraviolets, l'oxyde métallique étant l'oxyde de zinc.

2. Film photostabilisé selon la revendication 1, qui est utilisé en tant que composant d'une cellule photovoltaïque.
